# EUROPÄISCHE PATENTSCHRIFT

(11) **EP 0 799 425 B1**
(45) Veröffentlichungstag und Bekanntmachung des Hinweises auf die Patenterteilung: **24.02.1999**
(21) Anmeldenummer: 95942019.1
(22) Anmeldetag: 14.12.1995
(51) Int. Cl.: G01R 33/022, G01R 33/035

(54) **GRADIOMETER**
GRADIOMETER
GRADIOMETRE

(30) Priorität: 21.12.1994 DE 4445700
(43) Veröffentlichungstag der Anmeldung: 08.10.1997
(73) Patentinhaber: FORSCHUNGSZENTRUM JÜLICH GMBH, 52425 Jülich (DE)
(72) Erfinder: ZHANG, Yi, D-52428 Jülich (DE); WOLF, Walter, D-52428 Jülich (DE); BOUSACK, Herbert, D-52080 Aachen (DE); SOLTNER, Helmut, D-52459 Inden (DE)
(86) Internationale Anmeldenummer: DE9501816
(87) Internationale Veröffentlichungsnummer: WO9619736

(56) Entgegenhaltungen:
- EP-A- 0 501 220
- US-A- 5 053 834
- 1990 APPLIED SUPERCONDUCTIVITY CONFERENCE, SNOWMASS, CO, USA, 24-28 SEPT. 1990, Bd. 27, Nr. 2, pt.4, ISSN 0018-9464, IEEE TRANSACTIONS ON MAGNETICS, MARCH 1991, USA, Seiten 2963-2966, XP000567983 MATLASHOV A N ET AL: "High sensitive magnetometers and gradiometers based on DC SQUIDs with flux focuser"
- JOURNAL OF APPLIED PHYSICS, 1 DEC. 1985, USA, Bd. 58, Nr. 11, ISSN 0021-8979, Seiten 4322-4325, XP000567976 KETCHEN M B: "Design of improved integrated thin-film planar DC SQUID gradiometers"
- IEICE TRANSACTIONS ON ELECTRONICS, AUG. 1994, JAPAN, Bd. E77-C, Nr. 8, ISSN 0916-8524, Seiten 1185-1190, XP000470609 ITOZAKI H ET AL: "Multi-channel high T/sub c/ SQUID"
- NTIS TECH NOTES, 1.März 1990, Seite 233 XP000127249 "SQUID WITH INTEGRAL FLUX CONCENTRATOR"

## Beschreibung

Die Erfindung betrifft ein Gradiometer mit zwei jeweils eine SQUID-Schleife enthaltenden SQUIDs.

Für die quantitative Untersuchung von Magnetfeldern bzw. Magnetfeldgradienten, beispielsweise im Bereich der zerstörungsfreien Werkstoffprüfung oder im Bereich biomagnetischer Untersuchungen mit Hilfe von SQUIDs, ist die Herstellung von Gradiometern zur Unterdrückung von Störfeldern sehr erwünscht. Zu solchen Störungen zählen Fluktuationen des Erdfeldes sowie die Felder, die durch künstliche, elektromagnische Belastung unserer Umwelt, wie beispielsweise die 50 Hz-Wechselfelder, zustande kommen. Auf der Basis von Tief-T_{c}-Materialien sind bereits Gradiometer bekannt, die mit relativ geringem Aufwand hergestellt werden. Dazu stehen duktile Drähte zur Verfügung, mit deren Hilfe die Herstellung geschlossener Spulenpaare mit zum Teil gegensinniger Windungsrichtung, was zu einer Elimination von Feldern mit geringem Gradienten führt, erlaubt. Im Bereich der Hoch-TC-Materialien stehen derzeit keine geeigneten Drähte zur Verfügung.

Bekannt aus Supercond. Sci. Technol. 7 (1994), 265-268 sind sog. axiale Gradiometer, bei denen zwei SQUIDs in bis zu einigen Zentimetern entfernten Ebenen zueinander angeordnet sind. Dabei werden die Signale der einzelnen SQUIDs in getrennten elektronischen Systemen weiterverarbeitet, insbesondere voneinander subtrahiert. Auch aus IEICE Transactions on Electronics, Bd. E77-C, Nr. 8 (August 1994), Seiten 1185 - 1190 ist als Stand der Technik ein Gradiometer mit zwei jeweils eine SQUID-Schleife enthaltenden SQUIDs bekannt, wobei die SQUIDs zueinander so angeordnet sind, daß die SQUID-Schleifen um eine Basislänge voneinander entfernt in einer Ebene liegen.

Diese Gradiometer zeigen nachteilig einen hohen Fetigungsaufwand und zudem eine aufwendige mechanische Abgleichung. Außerdem ergeben sich im Falle eines solchen Gradiometers mit zwei SQUIDs Gradientensignale, die nur mit Hilfe eines weiteren, dritten SQUIDs - auf diese Weise einen Gradiometer zweiter Ordnung bildend, - unterdrückt werden können.

Des weiteren ist aus Appl. Phys. Lett. 56 (1990) 1579 ein Gradiometer bekannt, bei dem der Josephson-Kontakt symmetrisch zwischen zwei relativ weit entfernten SQUID-Schleifen liegt und mit diesen durch dünne Schlitze miteinander verbunden ist. Ein solches Gradiometer weist den Nachteil auf, daß man sich auf geringe Basislängen (Entfernung der Mitten der jeweiligen SQUID-Schleife zueinander) beschränken muß, da sonst die SQUID-Induktivität zu groß und folglich das SQUID-Signal zu klein wird.

Es ist deshalb Aufgabe der Erfindung, ein Gradiometer zu schaffen, bei dem auf vergleichsweise einfache Art und ohne die bei bekannten Gradiometern aufgezeigten Nachteile eine erhöhte Meßgenauigkeit des magnetischen Feldes bzw. des Magnetfeldgradienten erreicht wird.

Die Aufgabe wird gelöst durch ein Gradiometer mit der Gesamtheit der Merkmale gemäß Anspruch 1.

Es wurde erkannt, daß bei Anlegen insbesondere eines homogenen Magnetfeldes senkrecht zur Gradometerebene im Flußkonzentrator Abschirmströme am Außenrand induziert werden, die jeweils an den Orten der SQUIDs gleich große, konzentrierte Magnetfelder erzeugen. Das durch Subtraktion der jeweiligen Signale der einzelnen SQUIDs erhaltene Differenzsignal ist in einem solchen Gradiometer frei von räumlich homogenen Störsignalen. Inhomogene Felder jedoch werden unterschiedlich stark in den einzelnen SQUIDs konzentriert und bilden das in diesem Falle von Null verschiedene Differenzsignal.

Das erfindungsgemäße Gradiometer weist den besonderen Vorteil auf, daß eine bestimmte, erwünschte Basislänge des Gradiometers durch geeignete konstruktive Maßnahmen eingestellt werden kann, ohne daß es zu einer Vergrößerung der Induktivität und eine damit verbundene Verringerung des Signal des Gradiometers kommt.

Bei einer besonderes vorteilhaften Ausführungsform des Gradiometers gemäß Anspruch 2 ist vorgesehen, daß der Flußkonzentrator in der zu seiner Oberfläche senkrechten Spiegelsymmetrieebene zur Ausbildung von einander elektrisch isolierten Flußkonzentratorteilen eine elektrisch isolierte, die beiden Teile verbindende Schicht aufweist. Dadurch werden die Abschirmströme am Rande der jeweiligen Flußkonzentratorteile jeweils an die SQUID-Schleifen vorbeigeführt und erzeugen dabei am Ort des SQUIDs gleich große, konzentrierte Magnetfelder.

In besonders vorteilhafter Weise ist gemäß Anspruch 3 vorgesehen, daß wenigstens ein weiterer SQUID, der in der Ebene der beiden ersten SQUIDs liegt, vorgesehen ist, wobei der Flußkonzentrator daraufhin so ausgebildet ist, daß er auch diesen SQUID umschließt. Auf diese Weise erhält man ein Gradiometer mit mehreren, unterschiedlichen räumlichen Orientierungen aufweisende Basislängen, die jeweils ein Einzelgradiometer darstellen.

Besonders vorteilhaft wird das Gradiometer durch im kennzeichnenden Teil gemäß Anspruch 4 aufgeführten Merkmale. In diesem Fall erhält man ein planares Gradiometer, das in zwei unabhängigen, räumlichen Orientierungen zur Bestimmung von Magnetfeldern bzw. Magnetfeldgradienten geeignet ist.

Es ist gemäß Anspruch 5 zweckmäßig, zum Abgleichen der im Gradiometer befindlichen SQUIDs eine Abgleichplatte vorzusehen, die, aus supraleitendem Material bestehend, parallel zur Ebene des Flußkonzentrators verschiebbar angeordnet ist. In vorteilhafter Weise soll der Flußkonzentrator dabei im Bereich der Basislinie(n) verschiebbar angeordnet sein.

Es ist dabei sogar vorstellbar, daß als Abgleichplatte ein zusätzlicher Magnetometer-SQUID vorgesehen wird.

In diesem Falle ist sogar ein aktiver Abgleich erreichbar.

Eine besonders vorteilhafte Ausführungsform des Gradiometers erhält man gemäß Anspruch 6, indem als Material zur Bildung des Flußkonzentrators und/oder der Abgleichplatte ein Hochtemperatur-Supraleiter (HTSL) gewählt wird. Die zu diesem Material gehörenden vorteilhaften Eigenschaften sind auf ein solches Gradiometer voll übertragbar, insbesondere der Einsatz im Bereich des flüssigen Stickstoffs.

Soweit gemäß Anspruch 7 das Gradiometer wenigstens einen Washer-SQUID, wie er beispielsweise aus Appl. Phys. Lett. 60 (1992) 645 bekannt ist, oder sogar ausschließlich Washer-SQUIDs, vorzugsweise als HTSL-Washer-SQUID, aufweist, liegt ein besonders vorteilhaftes, in Dünnschichttechnologie herstellbares Gradiometer vor. Dabei kann der Flußkonzentrator als HTSL-Dünnschicht auf einem Substrat aufgebracht zum Einsatz kommen.

Im folgenden wird die Erfindung anhand von Ausführungsbeispielen und Figuren näher erläutert.

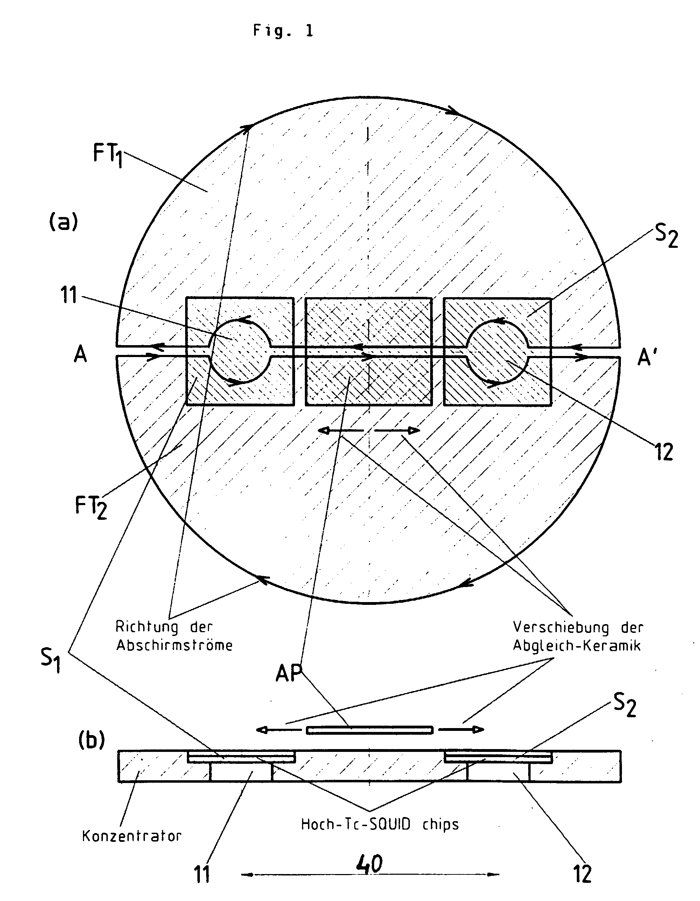

In der Figur 1 ist schematisch in Draufsicht (Figur la) und im Querschnitt entlang der Linie AA' (Figur 1b) ein Gradiometer mit massivem, kreisscheibenförmigem Konzentrator dargestellt.

Dieser Konzentrator aus HTSL-Material wurde verfahrensmäßig wie folgt hergestellt:

aus einem massiven Stück HTSL, hier YBa₂Cu₃O₇, wurde eine Kreisscheibenform geschnitten; diese wurde in zwei gleich große, halbkreisscheibenförmige Teile getrennt, die beide mit halbkreisscheibenförmigen Öffnungen an der Trennlinie AA' in einem Abstand der Basislänge L₁ zueinander versehen wurden; schließlich wurden beide Teile mit Hilfe eines elektrisch isolierenden Klebers zur Bildung des Konzentrators F als Kreisscheibenform mit zwei kreisscheibenförmigen Öffnungen 11 und 12 im Abstand L₁ zusammengefügt.

Im einzelnen zeigt Figur la die beiden halbkreisscheibenförmigen Teile FT₁ und FT₂ mit kreisscheibenförmigen Öffnungen 11 und 12 im Abstand L₁. Die Öffnungen 11 und 12 sind in diesem speziellen Falle so ausgebildet, daß sie zur Aufnahme von zwei quaderförmigen Washer-SQUIDs S₁ und S₂ an der Oberseite des Konzentrators F entsprechende Vertiefungen aufweisen.

Zum Abgleichen ist eine verschiebbare Abgleichplatte AP aus HTSL im Bereich zwischen den Positionen der beiden SQUIDs S₁ und S₂ vorgesehen. Dabei ist die Platte AP in diesem speziellen Fall rechteckig ausgebildet, obwohl auch andere Formen gewählt werden könnten.

Die sich bei den Einsatztemperaturen ausbildenden, supraleitenden Abschirmströme im Konzentrator F sind in der Figur la in Form von mit Pfeilen versehenen Schleifen angedeutet. Die Ströme bilden sich dabei am Rande des jeweiligen halbkreisscheibenförmigen Teiles FT₁ und FT₂ aus und man erhält auf diese Weise wegen der in den beiden Teilen FT₁ und FT₂ an der jeweiligen Öffnung 11 bzw. 12 entgegengesetzten Stromrichtung an diesen Öffnungen 11 bzw. 12 einen Ringstrom, der im Falle der Positionierung der SQUIDs S₁ und S₂ in der jeweiligen Ausnehmung im Konzentrator F eine Flußfokussierung des Magnetfeldes in die SQUID-Schleife des jeweiligen SQUIDs bewirkt.

Der massive Konzentrator F hatte einen Durchmesser von 50 mm bei einer Kreisscheibendicke von 3 mm. Die Öffnungen 11 bzw. 12 hatten jeweils einen Durchmesser von 6 mm. Die Basislänge L₁ wurde in diesem Falle zu 30 mm gewählt. Die rechteckigen, den jeweiligen Washer-SQUID enthaltenden Substrate S₁ und S₂ waren 10*10 mm² groß, die dazu gebildeten Ausnehmungen hatten einen nur geringfügig größeren Wert.

Bei Wahl anderer Geometrien der Teile dieses Gradiometers kann ein den gewünschten Gradiometereigenschaften entsprechendes Gradiometer mit mehr oder weniger großer Basislänge erhalten werden.

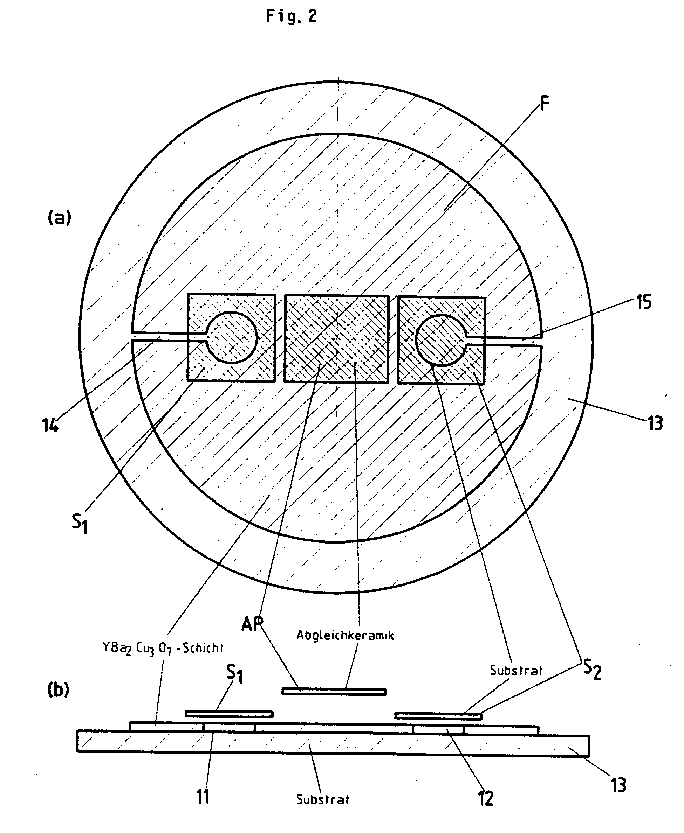

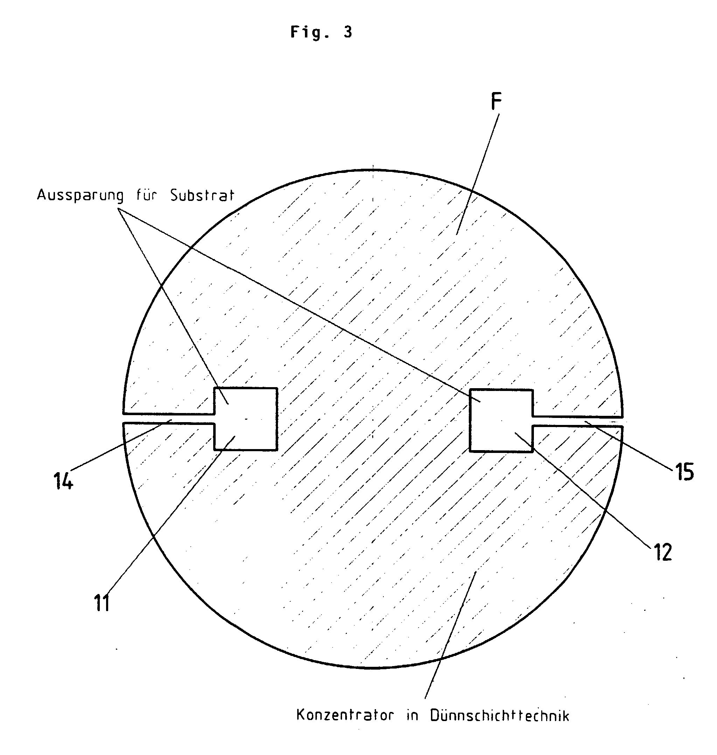

In der Figur 2 ist ein Gradiometer schematisch dargestellt, das einen Flußkonzentrator F in Dünnschichttechnik aufweist. Dazu wurde auf einem kreisförmigen Substrat 13 mit bekannter Maskentechnik eine kreisrunde YBa₂CU₃O₇-Schicht gebildet, die mit zwei Öffnungen 11 bzw. 12 und jeweils mit einem HTSL-freien Steg 14 bzw. 15 bis an den Rand der kreisrunden Schicht F versehen waren. Auf diese Weise bilden sich beim Einsatz Abschirmströme am Rande dieses Dünnschichtflußkonzentrators F aus, die mit den Strömen im Gradiometer gemäß Figur 1 vergleichbare Ringströme an den jeweiligen Öffnungen 11 und 12 (Durchmesser 6 mm) bilden. Die kreisrunde Schicht F hatte einen Durchmesser von 48 mm, die Breite der Stege 14 und 15 betrug 6 µm, ihre Länge etwa 10 mm. Die Figur 3 zeigt die laterale Form des Dünnschichtkonzentrators des in der Figur 2 gezeigten Gradiometers.

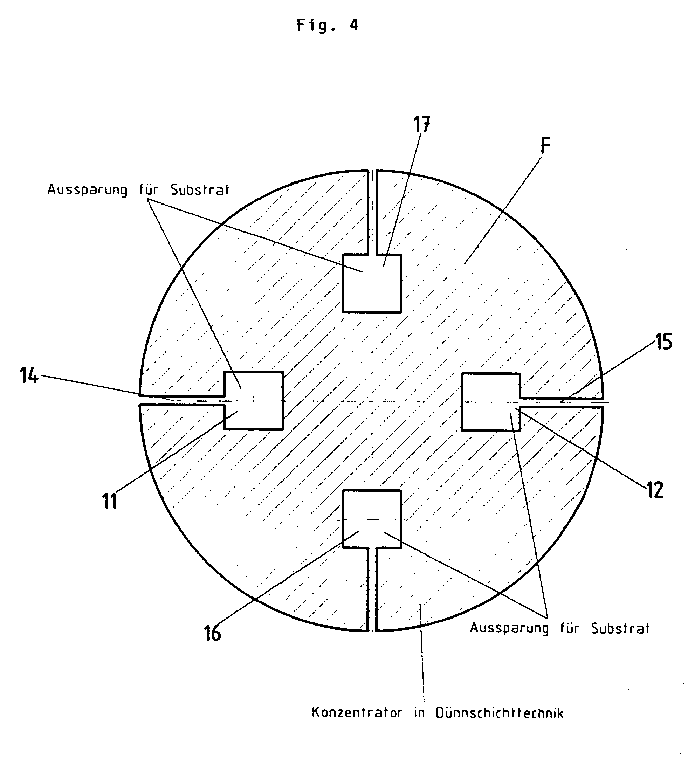

Eine Variante dieses Gradiometers mit Dünnschichtkonzentrator F kann an Stelle von zwei (11, 12), nunmehr vier SQUID-Ausnehmungen 11, 12, 16 und 17 enthalten, wie schematisch in Figur 4 für einen dementsprechend in Dünnschichttechnik hergestellten Flußkonzentrator F in Draufsicht dargestellt. Damit erhält man ein Gradiometer, das mit Hilfe von vier SQUIDs in zwei lateral unabhängigen Orientierungen die Bestimmung des aufzunehmenden Magnetfeldes bzw. des Magnetfeldgradienten ermöglicht.

Der Konzentrator soll so ausgebildet sein, daß die Ringströme an den Rand der jeweiligen Öffnung (11, 12, 16, 17) für den jeweiligen SQUID entlang gezwungen werden.

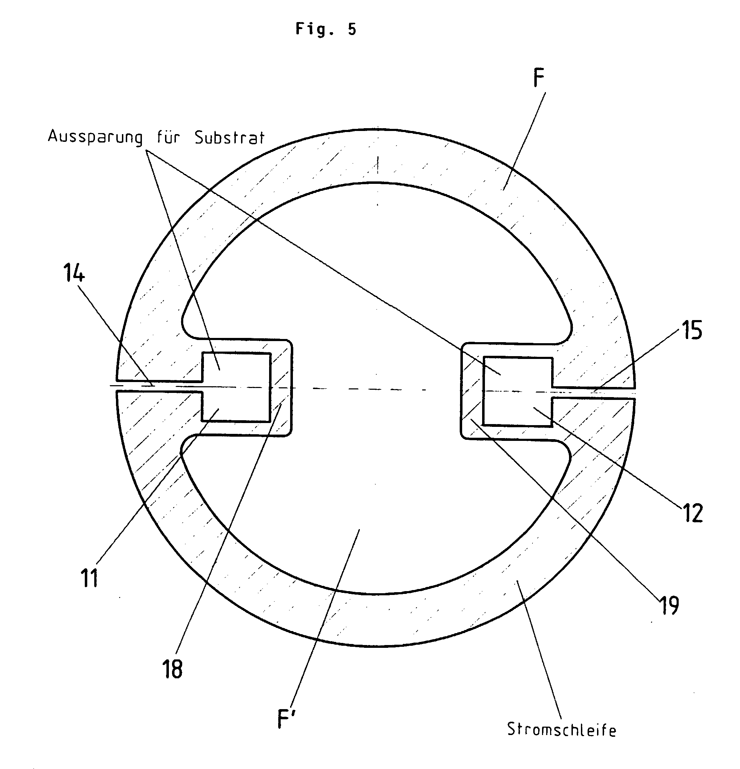

Eine weitere Variante des Konzentrators hatte dabei eine laterale Schichtstrukturierung, wie in der Figur 5 schraffiert dargestellt.
In Gegensatz zu der Schichtstruktur des Konzentrators zu Figur 4 wurde hier auf HTSL-Material im mittleren Bereich F' der kreisförmigen Schicht F weitgehend verzichtet. Der die jeweilige Öffnung 11, 12 innenliegend umlaufende HTSL-Steg 18 bzw. 19 in der Figur 5 hatte eine Breite von nur noch 3 mm.

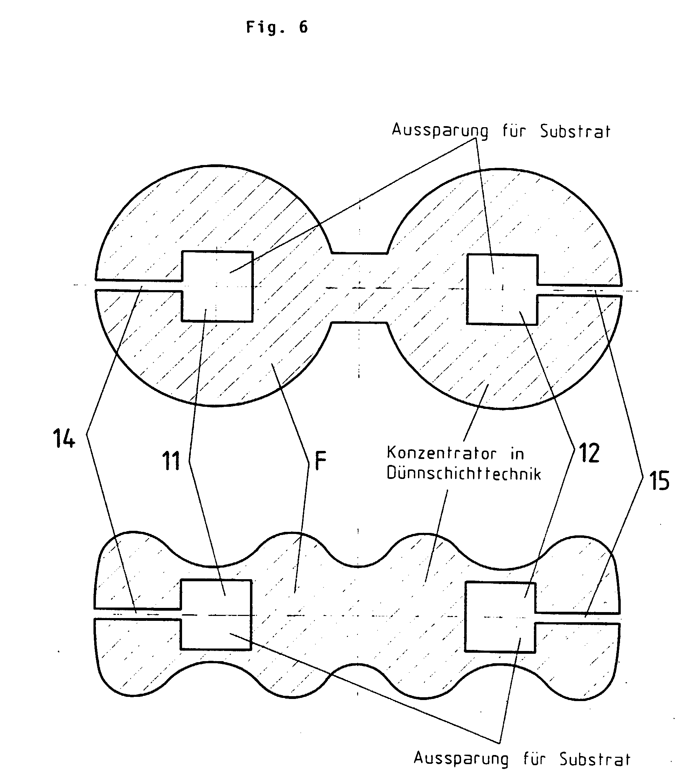

Im übrigen ist eine äußere, kreisförmige Berandung des Konzentrators F in Dünnschichttechnik oder bei massiver Ausbildung nicht zwingend. Vielmehr sind auch davon abweichende Formen vorstellbar. Dazu sind in der Figur 6 zwei weitere laterale Ausbildungen eines geeigneten Konzentrators F in Dünnschichttechnik für das Gradiometer dargestellt.

Beide Formen weisen eine Symmetrie bezüglich der Basislinie und ihrer Mittelsenkrechten auf.

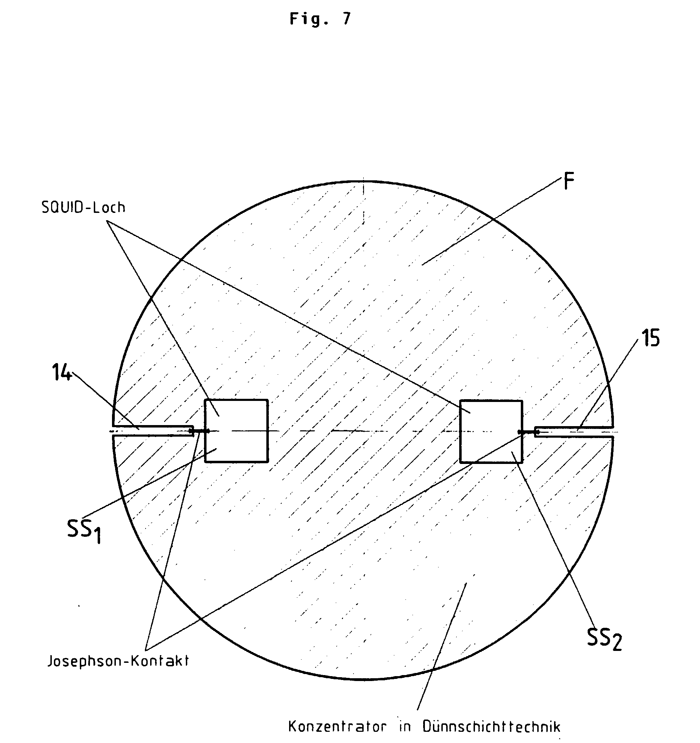

In den Figuren 7 bis 10 wurden nicht nur der Konzentrator F sondern auch die jeweiligen SQUID-Funktionen SS₁, ... integriert in Dünnschichttechnik ausgeführt.

Es sei in diesem Zusammenhang darauf hingewiesen, daß die hier gezeigten Öffnungen sowohl die Funktion der Flußfokussierung 11, 12, 16, 17 als auch gleichzeitig die SQUID-Funktion SS₁, ... ausüben. Dabei stellt der jeweilige kleine Verbindungsstrich zwischen der jeweiligen rechteckigen Öffnung 11, 12, 16, 17 und dem jeweiligen diese mit dem Rand des Konzentrators verbindenden Steg 14, 15, 20, 21 schematisch den zur Bildung der SQUID-Funktion SS₁, ... vorgesehenen Josephson-Kontakt dar. Geometrisch erscheinen im Vergleich zu den bisherigen Figuren 1 bis 6 die Öffnungen 11, 12, 16, 17 bzw. SS₁, ... ebenfalls etwa 10*10 mm² groß; tatsächlich sind die Öffnungen 11, 12, 16, 17 bzw. SS₁, ... in den Figuren 7 bis 10 jedoch zur Bildung der SQUID-Funktion SS₁, ... nur 200*200 µm². Es wurden auch Gradiometer mit 20*20 µm² großen SQUID-Funktionen hergestellt.

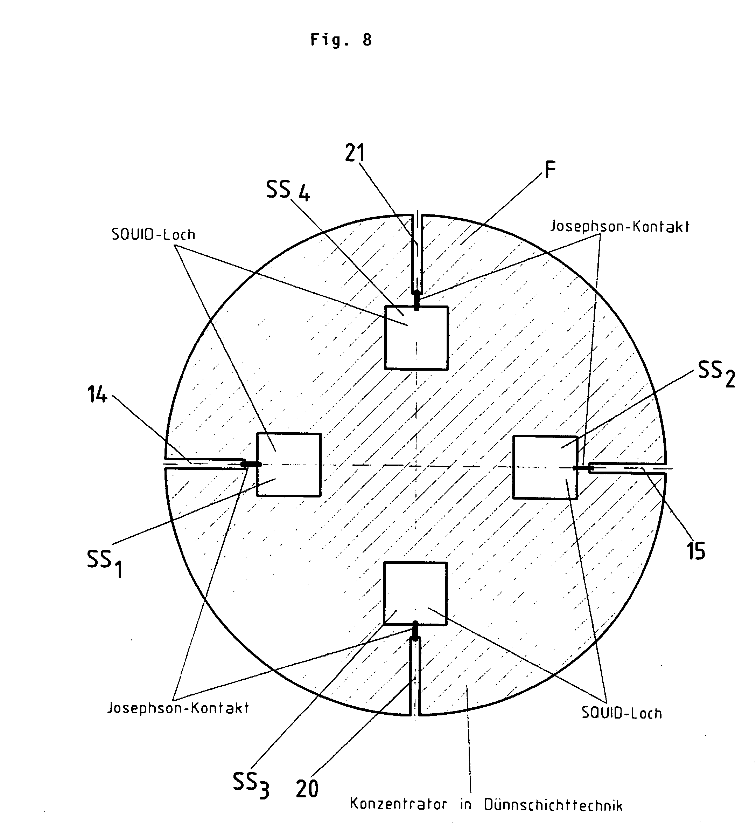

In der Figur 8 ist ein Gradiometers in Dünnschichttechnik mit kreisförmigem Konzentrator F und vier in diesem integrierten SQUID-Funktionen SS₁, SS₂, SS₃ und SS₄ in Draufsicht dargestellt.

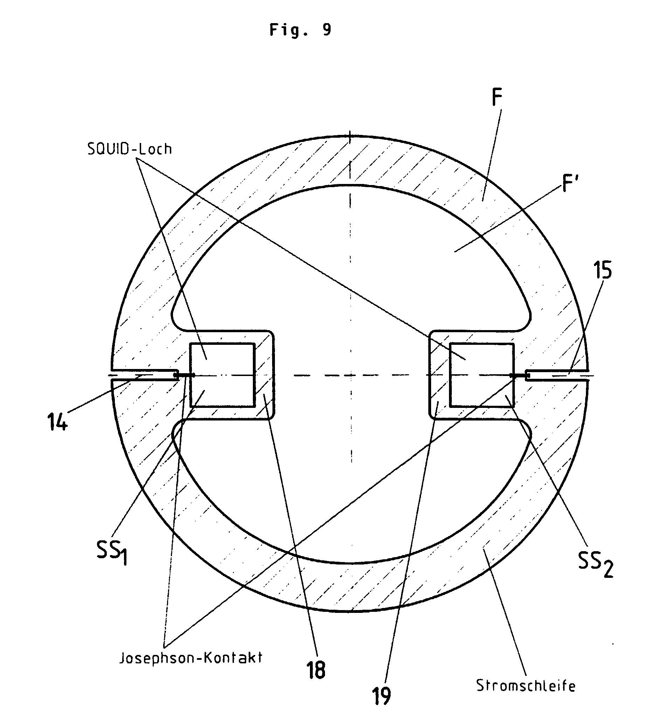

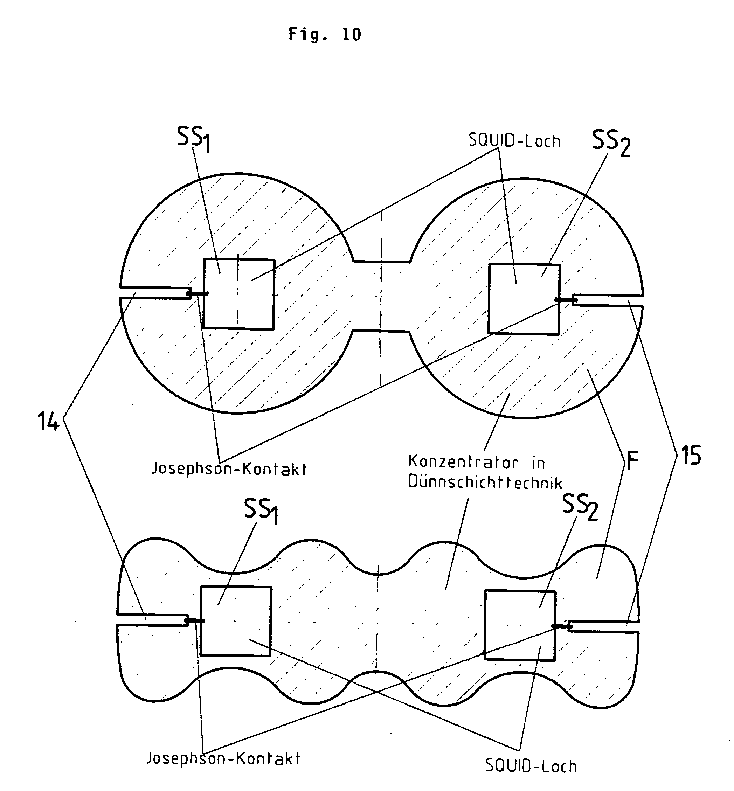

Figur 9 zeigt eine Variante des Gradiometer mit zwei SQUID-Funktionen SS₁ und SS₂ integriert in einem Dünnschichtkonzentrator F. Zwei weitere, von der Kreisform abweichende Varianten zur Ausbildung eines Gradiometers mit integrierten SQUID-Funktionen SS₁ und SS₂ im Konzentrator F zeigt schließlich Figur 10. Die hier angegebenen Ausführungsformen des Gradiometers stellen nur beispielhaft mögliche Ausbildungen der Erfindung dar. Geometrisch sind viele weitere Kombinationen einzelner Elemente der hier beschriebenen Gradiometervarianten, je nach gewünschten oder vorgegebenen Randbedingungen, denkbar.

## Patentansprüche

1. Gradiometer mit zwei jeweils eine SQUID-Schleife (SS₁, SS₂) enthaltenden SQUIDs (S₁, S₂), wobei die SQUIDS (S₁, S₂) zueinander so angeordnet sind, daß die SQUID-Schleifen (SS₁, SS₂) um eine Basislänge (L₁) voneinander entfernt in einer Ebene (E) liegen, **dadurch gekennzeichnet, daß**
ein diese Ebene enthaltender flächiger Flußkonzentrator (F) beide SQUID-Schleifen (SS₁, SS₂) umschließt und
der Flußkonzentrator (F) zu der die Mitten der beiden SQUID-Schleifen (SS₁, SS₂) miteinander verbindende Basislänge spiegelsymmetrisch ausgebildet ist.

2. Gradiometer nach Anspruch 1,
**dadurch gekennzeichnet,**
daß der Flußkonzentrator (F) in der zu seiner Oberfläche senkrechten Spiegelsymmetrieebene zur Ausbildung voneinander elektrisch isolierter Flußkonzentratorteilen (FT₁, FT₂) eine elektrisch isolierende, die beiden Teile verbindende Schicht aufweist.

3. Gradiometer nach einem der Ansprüche 1 oder 2,
**gekennzeichnet durch**
wenigstens einen weiteren SQUID (S₃), deren SQUID-Spule in der Ebene der beiden ersten SQUID-Spulen (SS₁, SS₂) liegt, wobei der Flußkonzentrator (F) so ausgebildet ist, daß er diesen SQUID (S₃) umschließt.

4. Gradiometer nach einem der Ansprüche 1 bis 3,
**gekennzeichnet durch** wenigstens ein Paar weiterer in der SQUID-Schleifen-Ebene der ersten liegenden SQUIDs (S₃, S₄), das zur Orientierung der Basislänge der ersten SQUID nicht parallel, insbesondere senkrecht, ausgerichtet ist.

5. Gradiometer nach einem der vorhergehenden Ansprüche, **gekennzeichnet durch** eine supraleitende Abgleichplatte (AP), die auf dem Flußkonzentrator (F) verschiebbar angeordnet ist.

6. Gradiometer nach einem der vorhergehenden Ansprüche
**gekennzeichnet durch**
hochtemperatur-supraleitendes Material (HTSL) zur Bildung des Flußkonzentrators (F) oder der Abgleichplatte (AP).

7. Gradiometer nach einem der vorhergehenden Ansprüche
**gekennzeichnet durch**
wenigstens einen Washer-SQUID.

## Claims

1. Gradiometer comprising two SQUIDs (S₁, S₂), each containing a respective SQUID loop (SS₁, SS₂), and the SQUIDs (S₁, S₂) are configured relative to each other in such a manner that the SQUID loops (SS₁, SS₂) lie separated from each other by a base length (L₁) in a plane (E), **characterised in that**
a surface flow concentrator (F) which contains this plane encases both SQUID loops (SS₁, SS₂), and
the flow concentrator (F) is configured mirror-symmetrically relative to the base length which joins the centres of both SQUID loops (SS₁, SS₂).

2. Gradiometer according to Claim 1, **characterised in that** the flow concentrator (F) comprises in the mirror-symmetrical plane which lies vertically to its surface an electrically insulating layer which joins both parts for the purpose of establishing flow concentrator parts (FT₁, FT₂) which are electrically insulated from each other.

3. Gradiometer according to one of Claims 1 or 2**, characterised by** at least one additional SQUID (S₃) the SQUID spool of which lies in the plane of the two first SQUID spools (SS₁, SS₂), and the flow concentrator (F) is designed in such a manner that it encases this SQUID (S₃).

4. Gradiometer according to one of Claims 1 to 3, **characterised by** at least one pair of additional SQUIDs (S₃, S₄) located in the SQUID loop plane of the first SQUIDs (S₃, S₄), which is for the purpose of orientation of the base length of the first SQUID not aligned in parallel, in particular vertically.

5. Gradiometer according to one of the above claims, **characterised by** a superconducting trimmer plate (AP) which is displaceably arranged on the flow concentrator (F).

6. Gradiometer according to one of the above claims, **characterised by** high-temperature super-conducting material for establishing the flow concentrator (F) or the trimmer plate (AP).

7. Gradiometer according to one of the above claims, **characterised by** at least one washer-SQUID.

## Revendications

1. Appareil de mesure de gradients comportant deux dispositifs SQUID (S₁,S₂) contenant chacun une boucle SQUID (SS₁, SS₂), les dispositifs SQUID (S₁,S₂) étant disposés l'un par rapport à l'autre de telle sorte que les boucles SQUID (SS₁,SS₂) sont séparées l'une de l'autre par une longueur de base (L₁) dans un plan (E), caractérisé en ce que
un concentrateur de flux (F) plat, qui est contenu dans ce plan, entoure les deux boucles SQUID (SS₁,SS₂), et le concentrateur de flux (F) est réalisé d'une manière symétrique par rapport à la longueur de base qui relie entre eux les centres des deux boucles SQUID (SS₁,SS₂).

2. Appareil pour la mesure de gradients selon la revendication 1, caractérisé en ce que le concentrateur de flux (F) comporte, dans un plan de symétrie perpendiculaire à sa surface, pour la formation de parties (FT₁,FT₂) du concentrateur de flux qui sont isolées électriquement l'une de l'autre, une couche électriquement isolante, qui relie les deux parties.

3. Appareil pour la mesure de gradients selon l'une des revendications 1 ou 2, caractérisé par au moins un autre dispositif SQUID (S₃), dont la bobine SQUID est située dans le plan des deux premières bobines SQUID (SS₁,SS₂), le concentrateur de flux (F) étant agencé de manière à entourer ce dispositif SQUID (S₃).

4. Appareil pour la mesure de gradients selon l'une des revendications 1 à 3, caractérisé en outre par au moins un couple d'autres dispositifs SQUID (S₃,S₄), qui sont situés dans le plan des boucles SQUID du premier dispositif SQUID et sont orientés de manière à ne pas être parallèles, mais notamment perpendiculaires à l'orientation de la longueur de base des premiers dispositifs SQUID.

5. Appareil pour la mesure de gradients selon l'une des revendications précédentes, caractérisé par une plaque supraconductrice de compensation (AP), qui est disposée de manière à être déplaçable sur le concentrateur de flux (F).

6. Appareil pour la mesure de gradients selon l'une des revendications précédentes, caractérisé par un matériau supraconducteur à haute température (HTSL) pour la formation du concentrateur de flux (F) ou de la plaque d'équilibrage (AP).

7. Appareil pour la mesure de gradients selon l'une des revendications précédentes, caractérisé par au moins un dispositif Washer-SQUID.
